# EUROPEAN PATENT APPLICATION

(11) **EP 4 354 508 A1**
(43) Date of publication of application: **17.04.2024**
(21) Application number: 22201457.3
(22) Date of filing: 13.10.2022
(51) Int. Cl.: H01L 29/06, H01L 29/40, H01L 29/66, H01L 29/78

(54) **SEMICONDUCTOR DEVICE AND METHOD OF PRODUCING A CAVITY IN A TRENCH**

(71) Applicant: Infineon Technologies Austria AG, 9500 Villach (AT)
(72) Inventor: HUTZLER, Michael, 9500 Villach (AT); BREYMESSER, Alexander, 9500 Villach (AT); JUHASZ, Laszio, 9500 Villach (AT)
(74) Representative: JENSEN & SON

(57) **Abstract**

In an embodiment, a semiconductor device is provided that comprises a semiconductor substrate having a first major surface, one or more trenches formed in the first major surface and having a base and a side wall extending from the base to the first major surface, an anchoring layer and a conductive member arranged in the trench and spaced apart from the side wall of the trench by a cavity formed in the trench. The anchoring layer extends from the first major surface of the semiconductor substrate over the cavity and onto an upper surface of the conductive member.

## Description

### BACKGROUND

To date, transistors used in power electronic applications have typically been fabricated with silicon (Si) semiconductor materials. Common transistor devices for power applications include Si Power MOSFETs, such as Si CoolMOSO, and Si Insulated Gate Bipolar Transistors (IGBTs).

A transistor device for power applications may be based on the charge compensation principle. In some designs, the transistor device has a superjunction structure for charge compensation. A superjunction structure includes a drift region with a plurality of regions of a first doping type (conductivity type) and a plurality of regions of a second doping type (conductivity type) complementary or opposite to the first doping type.

In other designs, the transistor device includes an active cell field including a plurality of trenches, each including a field plate for charge compensation. The field plate in the trenches is electrically insulated from the substrate by a field oxide. US 2017/0338338 A1 describes a method for fabricating a cavity in a recess formed in a semiconductor substrate. The cavity is formed between an electrically conductive filling material and the side wall of the recess.

It is desirable to reduce the size of power semiconductor devices whilst at least maintaining if not improving the performance and reliability of the device. Methods for fabricating a semiconductor device with reduced size and good performance are also desirable.

### SUMMARY

In an embodiment, a semiconductor device comprises a semiconductor substrate having a first major surface, one or more trenches formed in the first major surface and having a base and a side wall extending from the base to the first major surface, an anchoring layer and a conductive member arranged in the trench and spaced apart from the side wall of the trench by a cavity formed in the trench. The anchoring layer extends from the first major surface of the semiconductor substrate over the cavity and onto an upper surface of the conductive member.

In some embodiments, the conductive member is arranged in the trench and spaced apart from both the base and the side wall of the trench by the cavity formed in the trench

In some embodiments, the conductive member has a lower surface that opposes the upper surface and the lower surface is spaced apart from the base of the trench. The lower surface of the conductive member may be spaced apart from the base of the trench by a region of the cavity that is arranged not only between the sidewall of the conductive member and the sidewall of the trench but also extends under the conductive member and between the lower surface of the conductive member and the base of the trench. In other embodiments, the lower surface of the conductive member is spaced apart from the base of the trench by a dielectric material, for example a dielectric material in the solid state. The dielectric material may be silicon oxide and/or silicon nitride. Silicon oxide includes compositions such as SiO₂ (silicon dioxide) and SiOₓ.

The anchoring layer may be used to anchor the position of the conductive member within the trench. The anchoring layer is suspended above the cavity between the conductive member and the first major surface of the semiconductor substrate. The anchoring layer serves to hold or anchor the conductive member in position, since it provides a physical connection between the conductive member and the first major surface of the semiconductor substrate. In some embodiments, the anchoring layer acts as the only physical connection between the conductive member and the semiconductor substrate.

In embodiments in which the cavity is positioned between the base and the side wall of the trench and the conductive member, the anchoring layer provides the sole mechanical connection between the upper surface of the conductive member and the first major surface of the semiconductor substrate as the lower surface of the conductive member is free-lying within the cavity formed in the trench.

In embodiments in which a solid dielectric material is arranged on the base of the trench between the conductive member and the base of the trench, the solid dielectric material may act as an additional bottom anchor for the conducive member.

In some embodiments, the anchoring layer comprises at least one opening that is positioned at least partially above the cavity. The openings are in fluid communication with the cavity. The semiconductor device further comprises a sealing layer that is arranged on the anchoring layer and covers the at least one opening to seal the cavity. The opening may be positioned entirely above the cavity. In some embodiments, a part of at least one of the openings is positioned above the cavity and a part is positioned above one or both of the conductive member and the first major surface of the semiconductor substrate.

In some embodiments, a plurality of openings is formed in the anchoring layer. The remaining portion of the anchoring layer has a web or net structure bounding the openings. The web structure extends across the cavity formed in the trench between the conductive member and the first major surface of the semiconductor substrate.

The cavity in the trench is enclosed and sealed and is empty as it is free of solid dielectric material. The cavity may be filled with a vacuum or the process environment, e.g., gases and/or vacuum, present when the cavity is sealed. The cavity may also be called a void.

In some embodiments, the semiconductor device comprises a liner layer that covers the side wall and base of the trench and the side face and lower surface of the conductive member. The liner layer builds the walls of the cavity and is in contact with the anchoring layer at the top.

In some embodiments, the semiconductor device further comprises an interface layer arranged on the first major surface of the semiconductor substrate that leaves the trench uncovered. The interface layer may be in direct contact with the first major surface and arranged between the first major surface of the semiconductor substrate and the anchoring layer.

In some embodiments, the interface layer has a structure and lateral extent such that it is spaced apart from the sidewalls of the trench by a portion of the first major surface of the semiconductor substrate that is not covered by the interface layer. The anchoring layer is in direct contact with this portion of the first major surface of the semiconductor substrate that is uncovered by the interface layer. The anchoring layer may also further extend over the interface layer.

In some embodiments, the anchoring layer is formed of an electrically insulating material. The sealing layer may also be formed of an electrically insulating material.

The anchoring layer may be formed of a material with mechanical properties selected so as to prevent bending of the anchoring layer, which is suspended above the cavity between the side wall of the trench and the conductive member, due to electrostatic force, for example bending of the anchoring layer during operation of the device. In some embodiments, the anchoring layer is formed of a hard material, e.g. a material with a Young's modulus of at least 200 GPa. The anchoring layer may be formed of silicon nitride, for example which has a Young's Modulus of 300GPa. This hardness allows a reduction of the thickness of the top anchor material compared to other materials having a lower Young's Modules, e.g. Polysilicon which has a Young's Modulus of 100-150GPa.

The interface layer may comprise silicon oxide, for example silicon dioxide. The sealing layer may comprise silicon oxide, for example silicon dioxide and/or silicon nitride. The conductive member may comprise polysilicon.

In some embodiments, the interface layer comprises silicon oxide, the anchoring layer comprises silicon nitride and the sealing layer comprises silicon oxide and/or silicon nitride.

The semiconductor substrate may be formed of silicon, for example monocrystalline silicon or an epitaxially deposited silicon, i.e. a so-called epi layer that is formed on a base substrate.

In some embodiments, the upper surface of the conductive member is substantially coplanar with the first major surface of the semiconductor substrate.

In some embodiments, the trench is an elongate trench, such as an elongate stripe-like trench that is substantially rectangular in top view. An elongate trench has a length which extends parallel to the first major surface, its length being greater than its depth perpendicular to the first major surface and which is in turn greater than its width.

In these embodiments, the side wall of the trench has four side wall sections which are arranged substantially perpendicularly to one other to form a stripe-like rectangular trench. Typically, a plurality of trenches is provided which extend substantially parallel to one another so that a stripe-like mesa of the semiconductor material of the semiconductor substrate is formed between adjacent ones of the trenches.

For an elongate trench, the conductive member may also have an elongate shape and be stripe-like and substantially rectangular in top view. An elongate conductive member has a plurality of side wall sections which are arranged substantially perpendicularly to one other to form a stripe-like rectangular trench.

In some embodiments, the trench is a columnar trench which is also called a needle-shaped trench or needle trench. A columnar trench has a small or narrow circumference or width in proportion to its height / depth in the substrate. The columnar trench may have different shapes in plan view. For example, the columnar trench may have a square, octagonal, round or hexagonal shape in top view. A columnar trench may have a single side wall, for example if the trench is circular in plan view, or may have a plurality of side walls sections arranged at an angle to one another, for example if the columnar trench has a square, hexagonal or octagonal shape in plan view. Typically, a plurality of columnar trenches is provided. A mesa is formed by the regions of the semiconductor substrate arranged between neighbouring ones of the trenches.

The columnar trenches and consequently the columnar conductive members positioned in the trench may be arranged in a regular square grid array of rows and columns, or an offset rows or a hexagonal array, for example.

For a columnar trench, the conductive member is also columnar. The lateral shape of the columnar conductive member may be the same as the columnar trench, e.g. both the columnar trench and the columnar conductive member are circular, or may have different lateral shapes. For example, a circular conductive member may be arranged in a square, octagonal or hexagonal trench. If the conductive member is circular in plan view it has a single side wall. If the columnar member has a square or hexagonal shape in plan view, it has a plurality of side walls sections arranged at an angle to one another.

In some embodiments, the conductive member within the trench may be used for forming a capacitor.

In some embodiments, the semiconductor substrate comprises a first conductivity type and a plurality of transistor cells, each transistor cell comprising a drain region of the first conductivity type, a drift region of the first conductivity type on the drain region, a body region of a second conductivity type that opposes the first conductivity type on the drift region and a source region of the first conductivity type on the body region, a gate electrode, and the trench with the conductive member. In these embodiments, the semiconductor device comprises a transistor device and the conductive member provides a field plate. The field plates provide a charge compensation structure for the transistor device.

In some embodiments, the gate electrode is arranged in a gate trench arranged in a mesa formed between adjacent ones of the trenches with a field plate. The gate electrode is electrically insulated from the semiconductor substrate by an electrically insulating layer formed in the gate trench.

In embodiments including an interface layer, the interface layer covers the gate electrode. In some embodiments, the interface layer further covers the gate trench and also extends onto the first major surface of the semiconductor substrate in regions laterally adjacent the gate trench. In some embodiments, the interface layer has a structure and lateral extent such that it is spaced apart from the sidewalls of the trench including a field plate by a portion of the first major surface of the semiconductor substrate. The anchoring layer is in direct contact with this portion of the first major surface of the semiconductor substrate that is uncovered by the interface layer. The anchoring layer also further extends over the interface layer and is positioned on the interface layer above the gate trench.

The transistor device may be a vertical power transistor device, i.e. has a drift path that extends perpendicularly to the first major surface of the semiconductor substate. In some embodiments, the vertical transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

The semiconductor device may further comprise a metallization structure arranged on the first major surface. The metallization structure comprises at least one conductive layer and optionally one or more further electrically insulating layers that are arranged on the sealing layer. The metallization structure comprises a conductive redistribution structure for the source region, gate electrodes and field plates and provides a source pad electrically connected to the source region and field plates and a gate pad electrically connected to the gate electrodes. A drain pad is arranged on the opposing second surface of the semiconductor substrate that is electrically connected to the drain region.

In an embodiment, a method of producing a cavity in a trench is provided. The method comprises providing a semiconductor substrate having a first major surface. One or more trenches are formed in the first major surface and each have a base and a side wall extending from the base to the first major surface. A conductive member is arranged in the trench and is spaced apart from the base and the side wall of the trench by sacrificial material. An anchoring layer is applied to the first major surface such that it covers the trenches and in contact with an upper surface of the conductive member. At least one opening is formed in the anchoring layer that exposes the sacrificial material in the trench, the remainder of the anchoring layer extending between the first major surface of the semiconductor substrate in regions laterally adjacent the opening and upper surface of the conductive member. At least a portion of the sacrificial material is removed from the trench through the at least one opening. A sealing layer is deposited onto the first major surface, sealing the at least one opening and forming a cavity in the trench such that the conductive member is spaced apart from the side wall of the trench by the cavity.

This method may be used for fabricating a semiconductor device and a semiconductor device that comprise a transistor device with at least one trench comprising a field plate that is electrically insulated from the substrate by a cavity formed in the trench.

The sealing layer may be deposited onto the remainder of the anchoring layer such that the sealing layer extends over and seals the at least one opening in the underlying anchoring layer thus sealing and enclosing the cavity in the trench. The cavity may be filled with a vacuum and or gases, for example the process environment present when the cavity is sealed.

The anchoring layer forms a mask to assist in the partial or entire removal of the sacrificial material in the trench. After the removal of the sacrificial layer, the anchoring layer remains on the first major surface and serves to hold or anchor the conductive member in position within the trench, since it provides a physical connection between the conductive member and the first major surface of the semiconductor substrate. If all of the sacrificial material in the trench is removed, the anchoring layer acts as the only physical connection between the conductive member and the semiconductor substrate.

In some embodiments, the sacrificial material is removed entirely from the trench through the at least one opening. In other embodiments, the sacrificial material is removed partially from the trench. This may result in the sacrificial material forming a connection between the conductive member and the base of the trench. This remaining sacrificial material between the conductive member and the base of the trench can be used to form an additional lower anchoring for the conductive member. The remaining sacrificial material may have the form of a plug or pillar between the base of the trench and the lower surface of the conductive member.

In embodiments in which sacrificial material remains between the conductive member and the base of the trench and is able to form a lower anchoring for the conductive member, the upper anchoring layer may be omitted. In some embodiments, a method of producing a cavity in a trench comprises providing a semiconductor substrate having a first major surface and forming one or more trenches in the first major surface, each trench having a base and a side wall extending from the base to the first major surface. A conductive member is arranged in the trench and is spaced apart from the base and the side wall of the trench by sacrificial material. A portion of the sacrificial material is removed from the trench such that the sacrificial material remaining in the trench is arranged between the conductive member and the base of the trench. A sealing layer is deposited onto the first major surface, sealing and forming a cavity in the trench such that the conductive member is spaced apart from the side wall of the trench by the cavity.

In some embodiments, the opening has a lateral extent that is smaller than the thickness of the sacrificial material on the side wall of the trench. In other embodiments, the opening has a lateral extent such that it is positioned above the sacrificial material and one or both of the first major surface of the semiconductor substrate and the upper surface of the conductive member. The remaining portion of the anchoring layer extends between the conductive member and the first major surface.

An etching process, such as a wet etching process, may be used to remove the sacrificial material from the trench through the opening(s). The materials used for the sacrificial material and the anchoring layer are selected such that the sacrificial material is selectively etchable over the material of the anchoring layer. For example, the etch selectivity of the sacrificial material over the material of the anchoring layer may be around 100 to 1. An exemplary combination is silicon nitride for the anchoring layer and silicon dioxide for the sacrificial material.

The sacrificial material may be removed through the opening(s) by one or more methods which may also be used in succession. In some embodiments, the sacrificial material is at least partially removed by wet etching and/or plasma etching and/or gas chemistry.

The size and arrangement of the opening(s) may be selected depending on the selectivity of the removal of the sacrificial material over the material used for the anchoring layer, the conductive member and the semiconductor substrate.

In some embodiments, a plurality of openings is formed in the anchoring layer exposing the sacrificial material in the trench and the sacrificial material is removed from the trench through the plurality of openings. The remaining portion of the anchoring layer may have a web or net structure bounding the openings. The web structure extends across the sacrificial material. After the removal of the sacrificial material, the web structure extends over the cavity formed in the trench between the conductive member and the first major surface of the semiconductor substrate.

In some embodiments, the method further comprises, after removing the sacrificial material, forming a lining or liner layer on the base and side wall of the trench. The lining may also be formed on surfaces of the conductive member that are exposed from the sacrificial material. The lining may be formed of silicon oxide, e.g. silicon dioxide.

In some embodiments, the semiconductor substrate further comprises an interface layer arranged on the first major surface of the substate and on the trenches which are filled with the conductive member and the sacrificial material. The method further comprises removing regions of the interface layer from the first major surface such that the interface layer is spaced part from the side walls of the trenches by an exposed portion of the first major surface. The anchoring layer is then formed on the interface layer and directly on the exposed first major surface of the semiconductor substrate in regions contiguous to the trench.

The anchoring layer is, therefore, in direct contact with the first major surface in regions contiguous to the trench and may be arranged on the interface layer that is located in regions of the first surface positioned between adjacent ones of the trenches. The anchoring layer can be deposited as a closed layer and then the openings are formed so as to expose the sacrificial material in the trench.

In some embodiments, the semiconductor substrate comprises a first conductivity type and a plurality of transistor cells, each transistor cell comprising a drain region of the first conductivity type, a drift region of the first conductivity type on the drain region, a body region of the second conductivity type that opposes the first conductivity type on the drift region and a source region of the first conductivity type on the body region, a gate electrode, and the trench with the conductive member, wherein the conductive member provides a field plate. In these embodiments, the semiconductor substrate comprises a transistor device which may be a vertical transistor device, i.e. with a drift path that extends perpendicularly to the first major surface of the semiconductor substrate.

In some embodiments, the vertical transistor device is a MOSFET (Metal Oxide Semiconductor Field Effect Transistor) device, an insulated gate bipolar transistor (IGBT) device or a Bipolar Junction Transistor (BJT).

In some embodiments, the gate electrode is arranged in a gate trench and is electrically insulated from the semiconductor substrate by an electrically insulating layer formed in the gate trench. After the portions of the interface layer are removed, the interface layer covers the gate electrode and the gate trench and is in direct contact with the first major surface of the semiconductor substrate in regions contiguous to the gate trench. Portions of the first major surface contiguous to the trench comprising the conductive member are exposed from the interface layer.

In some embodiments, the anchoring layer is formed of a material with a Young's modulus of at least 200 GPa. The anchoring layer may be formed of silicon nitride, for example.

In some embodiments, the anchoring layer is formed of an electrically insulating material. The sealing layer may also be formed of an electrically insulating material.

The interface layer may comprise silicon oxide. The sealing layer may comprise silicon oxide, for example silicon dioxide and/or silicon nitride. The conductive member may comprise polysilicon.

The semiconductor substrate may be formed of silicon, for example monocrystalline silicon or an epitaxially deposited silicon, i.e. a so-called epi layer that is formed on a base substrate.

In some embodiments, the interface layer comprises silicon oxide, the anchoring layer comprises silicon nitride and the sealing layer comprises silicon oxide and/or silicon nitride.

In some embodiments, the upper surface of the conductive member is substantially coplanar with the first major surface of the semiconductor substrate.

In some embodiments, the trench is an elongate trench, such as an elongate stripe-like trench that is substantially rectangular in top view. In some embodiments, the trench is a columnar trench.

In some embodiments, the trench is an elongate trench, such as an elongate stripe-like trench that is substantially rectangular in top view. An elongate trench has a length which extends parallel to the first major surface, its length being greater than its depth from the first major surface and which is in turn greater than its width.

In these embodiments, the side wall of the trench has four side wall sections which are arranged substantially perpendicularly to one other to form a stripe-like rectangular trench. Typically, a plurality of trenches is provided which extend substantially parallel to one another so that a stripe-like mesa of the semiconductor material of the semiconductor substrate is formed between adjacent ones of the trenches.

In some embodiments, the trench is a columnar trench. A columnar or needle-shaped trench has a small or narrow circumference or width in proportion to its height / depth in the substrate. The columnar trench may have different shapes in plan view. For example, the columnar trench may have a square, octagonal, round or hexagonal top view shape. A columnar trench may have a single side wall, for example if the trench is circular in plan view, or may have a plurality of side walls sections arranged at an angle to one another, for example if the columnar trench has a square or hexagonal shape in plan view. Typically, a plurality of columnar trenches is provided. A mesa is formed by the regions of the semiconductor substrate arranged between neighbouring ones of the trenches.

The columnar trenches and consequently the conductive members positioned in the trench may be arranged in a regular square grid array of rows and columns, or an offset rows or a hexagonal array, for example.

For an elongate trench, the conductive member may also have an elongate shape and be stripe-like and substantially rectangular in top view. An elongate conductive member has a plurality of side wall sections which are arranged substantially perpendicularly to one other to form a stripe-like rectangular trench.

For a columnar trench, the conductive member is also columnar. The lateral shape of the columnar conductive member may be the same as the columnar trench, e.g. both the columnar trench and the columnar conductive member are circular, or may have different lateral shapes. For example, a circular conductive member may be arranged in a square, octagonal or hexagonal trench. If the conductive member is circular in plan view it has a single side wall. If the columnar member has a square or hexagonal shape in plan view, it has a plurality of side walls sections arranged at an angle to one another.

The method may further comprise forming a metallization structure comprising at least one conductive layer and optionally one or more further electrically insulating layers on the sealing layer. The metallization structure may be formed so as to provide a conductive redistribution structure for the source region, gate electrodes and field plates for embodiments including a transistor device. The metallization structure may provide a source pad electrically connected to the source region and field plates and a gate pad electrically connected to the gate electrodes. A drain pad is arranged on the opposing second surface of the semiconductor substrate that is electrically connected to the drain region.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a semiconductor device according to an embodiment.
Figure 2 illustrates a cross-sectional view of a semiconductor device according to an embodiment.
Figure 3, which includes figures 3A, 3B and 3C, illustrates a cross-sectional view and plan views of a semiconductor device according to various embodiments.
Figures 4 to 8 illustrate a method for fabricating a semiconductor device including a cavity in a trench.
Figure 9 illustrates a cross-sectional view of a semiconductor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The figures illustrate relative doping concentrations by indicating "-" or "+" next to the doping type "n" or "p". For example, "n-" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

It is generally desirable to further reduce the size of semiconductor devices. Some transistor devices such as silicon MOSFETs include a charge compensation structure which includes a field plate in a trench. The field plate is electrically insulated from the silicon substrate by an electrically insulating material such as silicon dioxide. Silicon dioxide has a relative dielectric constant of 3.9 and a bandgap of roughly 9eV. For a vacuum, these parameters are 1.0 and >20eV respectively. Therefore, it is proposed herein to replace the silicon dioxide at least in part by a vacuum to increase the isolation properties of the dielectric arranged between the field plate and the semiconductor substrate. This may be provided by a vacuum-filled cavity formed in the trench between the field plate and the semiconductor substrate.

Replacing silicon dioxide by vacuum in compensation devices such as a silicon MOSFET with a charge compensation structure in the form of a field plate in a trench, has at least the effect of enabling the reduction of dielectric thickness of the compensating element to achieve a similar compensation effect. This enables a reduction of the device pitch, e.g. by reducing the lateral size of the trenches and thickness of the isolation and/or reducing the spacing between the trenches, and correspondingly enables a reduction of Ron (On state resistance) x A (area). Furthermore, the larger bandgap raises the critical electrical field until dielectric breakdown occurs. This enables larger electrical fields across the dielectric and higher epitaxy doping of the silicon substrate with correspondingly lower R(on)xA.

In medium voltage MOSFET technologies e.g. 100V or 200V, among other technologies, a columnar trench concept, also known as a needle trench concept, has a good performance. It is therefore desirable to use a vacuum dielectric within this technology.

In an embodiment, a process for providing such a vacuum dielectric in a field plate compensation structure for a MOSFET may comprise, before forming the body and source implantations, forming a needle or columnar trench and inserting an oxide as dielectric and polysilicon as conductor. The gate trench is filled with gate oxide and polysilicon or TiN / tungsten as conductor. The whole device surface is covered by a thin liner of scattering oxide. Body and Source are implanted. In a lithography process, oxide is removed from the polysilicon as well as in a small mesa region around the trench. Next a nitride layer or another isolating material which can be etched selectively over the oxide is deposited. The nitride layer may be deposited using LPCVD or PECVD, which may, optionally, be followed by an RTP (Rapid Thermal Process) anneal. The nitride layer is structured by a lithography process and the dielectric in the trench, often referred to as the field oxide, is then removed through the holes in the nitride layer by plasma or wet or gas chemistry or a combination thereof. During this process, the polysilicon needle is kept in place by the nitride layer which acts as top anchor. The oxide etch chemistry cannot attack the scattering oxide on the mesa or the gate oxide since they are covered and isolated by the nitride layer. Silicon Nitride is a hard material with a Young's Modulus of 300GPa and suitable for preventing a bending of the top anchor later in application due to electrostatic force. This hardness allows a reduction of the thickness of the top anchor material compared to other solutions e.g. using polysilicon with a Young's Modulus of 100-150GPa. After a cleaning sequence, a thin oxide liner can be grown to avoid undefined mesa-vacuum-interface states. The void in the trench is closed by a directional HDP/USG (High Density Plasma deposition of Undoped Silicon Glass) deposition of a sealing layer. The material of the sealing layer may also be nitride, preventing moisture to enter the void. Thereby the field oxide is replaced by vacuum as a vacuum is present when the cavity is sealed.

On top a BPSG (Borophososilicate glass) layer may be deposited and a lithographic layer is used to etch the oxide/nitride/oxide/silicon in a stepwise fashion to form openings for contacts to the underlying structure. The nitride layer can act as an etch stop during contact etch, enabling improved groove depth uniformity. The process flow can now continue with the template flow: p+ contact implant and fabrication of the metallization structure.

This method is simple and inexpensive and provides a rigid and durable top anchor material that is present in the final product. The process and structure is not limited for use with columnar trenches and can also be used in stripe trench designs.

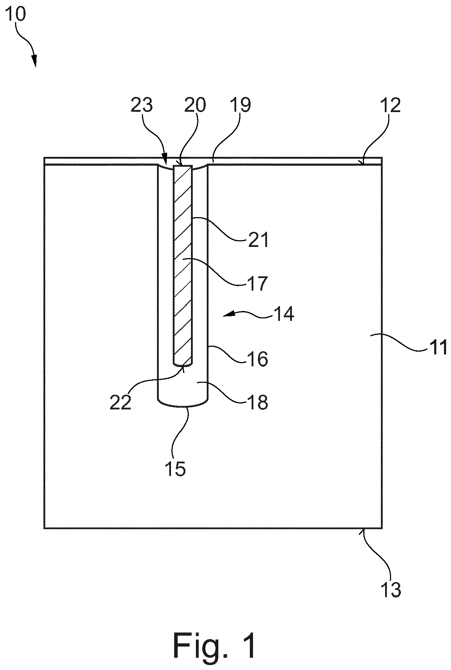

Figure 1 illustrates a cross-sectional view of a semiconductor device 10 according to an embodiment. The semiconductor device 10 comprises a semiconductor substrate 11 which has a first major surface 12 and a second major surface 13 opposing the first major surface 12. The semiconductor device 10 comprises at least one trench 14 which is formed in the major surface 12 and which has a base 15 and a sidewall 16 extending from the base 15 to the first major surface 12. Typically, the semiconductor device 10 includes a plurality of trenches 14, each of which may have the structure illustrated in figure 1. A conductive member 17 is arranged in the trench 14 and is spaced apart from the sidewall 16 and base 15 of the trench 14 by a cavity 18 that is formed in the trench 14. The semiconductor device 10 further comprises an anchoring layer 19 which is positioned on the first major surface 12 and which extends from the first major surface 12 over the cavity 18 arranged in the trench 14 and onto an upper surface 20 of the conductive member 17.

In some embodiments, the upper surface 20 of the conductive member 17 is coplanar with the first surface 12 of the semiconductor substrate. The conductive member 17 also has a side face 21 and a lower surface 22 that opposes the upper surface 20.

The cavity 18 is enclosed and sealed and can be considered to be empty as it is free of solid dielectric material. The cavity 18 may be filled with a vacuum or process environment, e.g. gases and/or vacuum, present when the cavity 18 is sealed. The cavity 18 may also be called a void. In the embodiment illustrated in figure 1, the cavity 18 is bounded at the bottom by the base 15 of the trench, at the sides by the side wall 16 of the trench 14, at the top by the anchoring layer 19 and by the lower surface 22 and side face 21 of the conductive member 17.

The side face 21 of the conductive member 17 is spaced apart from the sidewall 16 of the trench 14 by a portion of the cavity. The anchoring layer 19 is in direct contact with the first major surface 12 of the semiconductor substrate 11 and extends over the entire open end 23 of the trench 14 such that it extends between and is suspended between the sidewall 16 and the facing side face 21 of the conductive member 21. The anchoring layer 19 extends over and is in direct contact with the upper surface of the conductive member 21 and also extends and is suspended between the opposing portion of the side face 21' of the conductive member and opposing portion of the sidewall 16'of the trench 14 onto the first major surface 12 on the opposite side of the trench 14.

The anchoring layer 19 provides a support structure for determining the position of the conductive member 17 within the trench 14. The anchoring layer 19 may also be thought of as a supporting beam from which the conductive member 17 is suspended. In this embodiment, the lower surface22 of the conductive member 17 is spaced apart from the base 15 of the trench 14 by a portion of the cavity 18. The conductive member 17 is mechanically supported at only at one end since only the upper surface 20 and possibly uppermost regions of the side faces 21 of the conductive member are in physical contact with the anchoring layer 19. The lower surface 22 and side faces 21 are free-lying in the vacuum- and/or gas-filled cavity 18.

The substrate 11 may be formed of silicon, for example an epitaxial silicon layer, the conductive member be formed of doped polysilicon and the anchoring layer be formed by silicon nitride. Silicon nitride may be replaced by any material that has a Youngs modulus of at least 200 GPa and may also be electrically insulating.

The arrangement illustrated in figure 1 may be used to form for a field plate in a transistor device in which the conductive member 17 provides a field plate and the trench 14 provides the charge compensation structure for the transistor device.

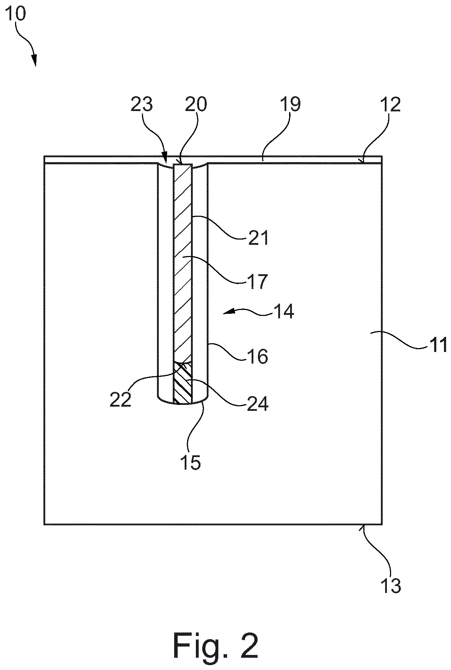

Figure 2 illustrates a cross-sectional view of a semiconductor device 10 according to another embodiment. The semiconductor device 10 includes a semiconductor substrate 11 comprising one or more trenches 14 formed in the first major surface 12 of the semiconductor substrate. A conductive member 17 is arranged in a trench 14 similar to the embodiments described with reference to figure 1. The conductive member 17 is spaced apart from the sidewall 16 of the trench 14 by a cavity 18. The semiconductor device 10 illustrated in figure 2 differs from that illustrated in figure 1 in that the lower surface 22 of the conductive member 17 is spaced apart from the base 15 of trench 14 by a solid-state dielectric material 24. In this embodiment, the cavity 18 does not extend under the lower surface 22 of the conductive member 17. The space between the lower surface 22 of the conductive member 17 and the base 15 of the trench 14 is filled with dielectric material 24 in the solid state. The dielectric material 24 may be silicon oxide, SiO₂ for example. The cavity 18 is bounded by the side wall 16 of the trench 14, the peripheral regions of the base 15 of the trench 14, the side face of the dielectric material 24, the side face 21 of the conductive member 17 and the anchoring layer 19 which extends across the open end 23 of the trench 14 between the conductive member 17 and the first major surface 12 of the semiconductor substrate 11.

In a top view, the trench 14 of any one of the embodiments described with reference to the drawings may have different forms. In some embodiments, the trench 14 is columnar and in other embodiments, the trench 14 is elongate. The cross-sectional view is the same for both of these lateral arrangements.

An elongate trench 14 may be a stripe-like trench that is substantially rectangular in top view. An elongate trench has a length which extends parallel to the first major surface, its length being greater than its depth from the first major surface and which is in turn greater than its width. In these embodiments, the side wall 16 of the trench 14 has a plurality of side wall sections 16' which are arranged substantially perpendicularly to one other to from a stripe-like rectangular trench 14.

In some embodiments, the trench 14 is a columnar trench. A columnar or needle-shaped trench 14 has a small or narrow circumference or width in proportion to its height / depth in the substrate 11. The columnar trench may have different shapes in plan view. For example, the columnar trench may have a square, octagonal, round or hexagonal top view shape. A columnar trench 14 may have a single side wall 16, for example if the trench is circular in plan view, or may have a plurality of side wall sections 16' arranged at an angle to one another, for example if the columnar trench has a square or hexagonal shape in plan view.

The conductive member 17 may have the same general shape as the trench 14. For example, for a columnar trench 14, the conductive member 17 may also be columnar. The shape of the conductive member 17 in plan view may be the same as or differ from the shape of the trench 14 in plan view. For example, the trench 14 may have a circular form in plan view and the conductive member 17 also have a circular form in plan view. In other example, the trench 14 may have a hexagonal form in plan view and the conductive member 17 a circular form in plan view.

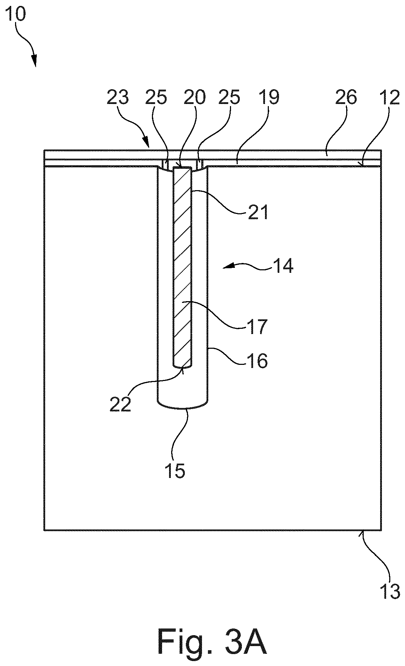

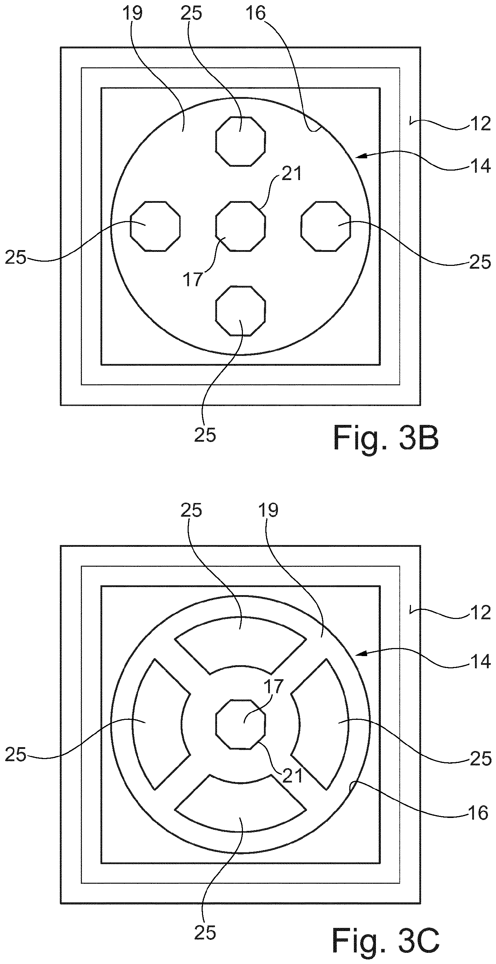

Figure 3A illustrates a cross-sectional view and Figure 3B and 3C a top view of a semiconductor device 10 which is similar to that illustrated in figure 1. In the cross-sectional view of figure 3A, two openings 25 in the anchoring layer 19 are shown. The openings 25 are positioned above the cavity 18 within the trench 14. The openings 25 are sized and shaped such that in planes of the semiconductor device 10 behind and in front of that shown in figure 3, the anchoring layer 19 extends continuously from the first major surface 12 over the gap formed by the cavity 18 between the sidewall 16 of the trench 14 and the side face 21 of the conductive member 17 onto the upper surface 20 of the conductive member 17 so as to support the position of the conductive member 17 within the trench 14. The openings or holes 25 each extend through the thickness of the anchoring layer 19 and are in fluid communication with the cavity 18. The semiconductor device 10 further comprises a sealing layer 26 which is positioned on the anchoring layer 19 and which extends over and seals the openings 25 and the cavity 18 within the trench 14.

One or more openings 25 may be provided. One or more openings 25 may be positioned exclusively above the cavity 18 or may partially overlap one or both of the first major surface 12 and the conductive member 17.

The structure of the anchoring layer 19 with the openings 25 and sealing layer 26 described with reference to figure 3A may also be used for embodiments in which a solid dielectric layer is arranged between the lower surface of the conductive member 17 and the base 15 of the trench 14 that provides a bottom support for the conductive member 17, for example as illustrated in figure 2.

Figure 3B illustrates a top view of the first major surface 12 of the semiconductor substrate 11 in which it can be seen that the trench 14 is a columnar trench that has a substantially circular form. The conductive member 17 also has a columnar shape and is substantially circular in plan view and is arranged at the centre of the columnar trench 14. In the embodiment shown in the plan view of figure 3B, it can be seen that four openings 25 are provided which are positioned above the trench 14 and between the sidewall 16 of the trench 14 and the side face 21 of the conductive member 17. Four openings 25 are uniformly distributed around the conductive member 17 and each has a substantially circular shape. Fewer, but at least one, or more than four openings 25 may be provided. The anchoring layer 19 extends continuously from the first major surface 12 between the openings 25 and over the cavity 18 to the upper surface 20 of the conductive member 17. The anchoring layer 19 provides a web or net-type structure defining the holes 25 and extends between the upper surface 20 of the conductive member 17 and the first major surface 12 of the substrate 11 in which the trench 14 is formed.

Figure 3C illustrates a top view of a semiconductor substrate according to another embodiment which differs from that illustrated in figure 3B by the shape of the openings 25. Four openings 25 are provided for each trench 14. Fewer, but at least one, or more than four openings 25 may be provided. Each opening 25 has the form of a segment of a ring. Each opening 25 has the form of a curved sections of a ring having a width which is less than the distance between the side face 21 of the conductive member 17 and the side face 16 of the trench 14 such that the curved segments are laterally spaced apart from the side face 21 of the conductive member 17 and the sidewall 16 of the trench 14 as well as one another by regions of the anchoring layer 19. In an embodiment, the width of the curved section of a ring is more than the distance between the side face 21 of the conductive member 17 and the side face 16 of the trench 14. The edge of the opening(s) 25 can also be located on the first major surface 12 and/or on the conductive member 17.

The four openings 25 are sized and positioned in the anchoring layer 19 such that regions of the anchoring layer 19 surround each of the openings 25 such that the regions of the anchoring layer 19 extend continuously from the first major surface 12 between the openings 25 and over the cavity 18 to the upper surface 20 of the conductive member 17. The anchoring layer 19 provides a web or net-type structure between the upper surface 20 of the conductive member 17 and the first major surface 12 of the substrate 11 in which the trench 14 is formed.

The openings 25 are used to provide a route through which sacrificial material arranged in the trench 14 between the side face 21 of the conductive member 17 and the sidewall 16 of the trench 14 can be removed in order to form the cavity 18 within the trench 14. The ratio of the total area provided by the openings 25 and the area of the open end 23 of the trench 14 may be selected such that the sacrificial material can be at least partially or entirely removed from the trench 14 using one or more etching processes, for example plasma etching or wet etching. After this sacrificial material has been removed though the openings 25, the sealing layer 26 is formed to seal the openings 25 and form an enclosed cavity 18 which is used to electrically isolate the conductive member 17 from the semiconductor substrate 11.

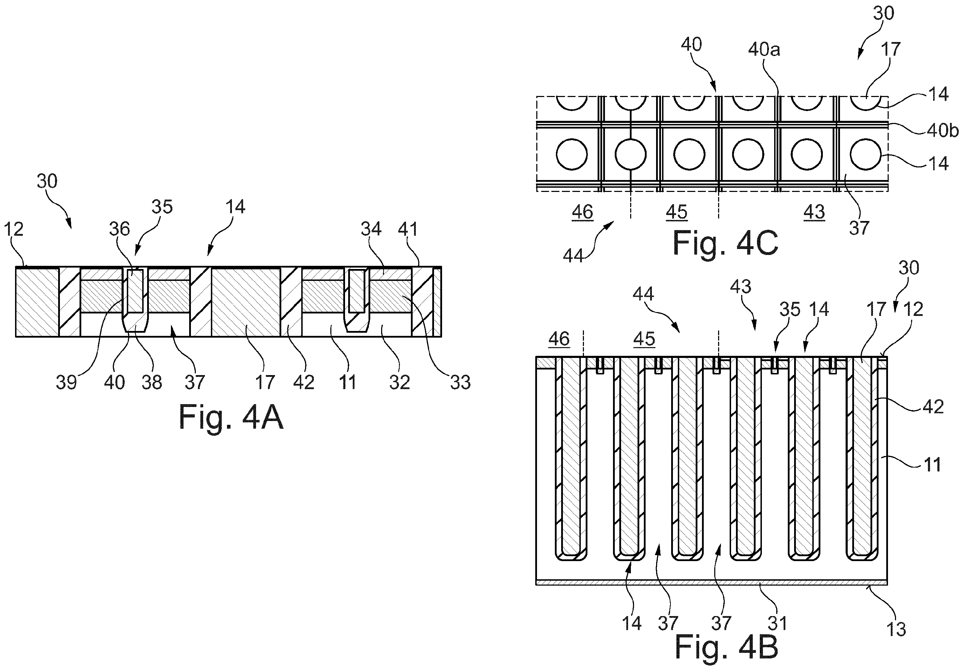

A method of fabricating a cavity in a trench will now be described with reference to figures 4 to 8. The method may be used to fabricate a semiconductor device, for example a transistor device 30, with a conductive member in a trench that is spaced apart from the sidewalls of the trench by a cavity. The method may be used to fabricate the arrangements shown in figures 1 to 3 and 9.

Each of figures 4 to 8 includes an enlarged cross-sectional view denoted A, a cross-sectional view denoted B and a top view denoted C, respectively.

In figures 4 to 8, the semiconductor substrate 11 comprises a first conductivity type, for example n-type, and a plurality of transistor cells. Each transistor cell comprises a drain region 31 of the first conductivity type, a drift region 32 of the first conductivity type arranged on the drain region 31, whereby the drift region 32 is more lightly doped than the drain region 31, a body region 33 of the second conductivity type, for example p-type, that opposes the first conductivity type, the body region 33 being arranged on the drift region 32 and a source region 34 of the first conductivity type arranged on or in the body region 33. Each transistor cell further includes a gate electrode 36 and one trench 14 with the conductive member 17 arranged within the trench 14 and a mesa 37 which is formed by the portion of the semiconductor substrate 11 located between adjacent ones of the trenches 14. The conductive member 17 in the trench 14 provides a field plate.

Figure 4A illustrates an enlarged cross-sectional view of the semiconductor substrate, figure 4B a cross-sectional view of the semiconductor substrate 11 and figure 4C a top view of the semiconductor substrate 11.

In the transistor device 30 described with reference to figures 4 to 8, the gate electrode 36 is arranged in a gate trench 35 which is located in the mesa 37 and between adjacent ones of the trenches 14. The gate electrode 36 is electrically insulated from the semiconductor substrate 11 by a gate insulating layer 38 which is arranged in the gate trench 35. The gate electrically insulating layer 38 is arranged on the sidewall 39 and base 40 of the gate trench 35 and may have a thickness on the base 40 of the gate trench 35 which is greater than its thickness on the sidewalls 39 of the gate trench 35.

In some non-illustrated embodiments, the gate electrode 36 is a planar gate that is arranged on the first major surface 12 of the semiconductor substrate 11.

Referring to the cross-sectional views of figures 4A and 4B, the trench 14 further comprises a sacrificial material 42 which lines the trench 14 and fills the gap between the field plate 17 and the sidewall 16 and base 15 of the trench 14. Referring to the top view of figure 4C, the trenches 14 which include a field plate 17 each have a substantially circular structure in top view and are columnar or needle-shaped as can be seen in the cross-sectional view of figure 4B. The columnar trenches 14 are arranged in a square grid array of rows and columns. The gate trenches 35 have an elongate structure and are formed in a square grid 40 of longitudinal sections 40a and transverse sections 40b whereby one longitudinal section 40a or transverse section 40b is arranged between adjacent ones of the array of columnar trenches 14. The gate electrode 36 also has a square grid form with longitudinal and transverse sections.

Referring to figure 4A, the semiconductor substrate 11 further comprises an interface layer 41 which extends continuously over the first major surface 12 such that it covers the source region 34 of the mesas 37, the gate trench 35 including the gate electrode 36 and the trench 14 including the sacrificial material 42, the upper surface 20 of the field plate 17. The interface layer 41 is also referred to as a scattering layer and may be deposited before the implantation of the body region 33 and source region 34.

Referring to figure 4B, the transistor device 30 comprises an active area 43, that is shown in the enlarged view of figure 4A, and an edge termination region 44 which laterally surrounds the active region 43. The edge termination region 44 comprises an inner edge termination region 45 which includes at least one trench 14 including a field plate 17 and at least one gate trench 35 comprising gate electrode 36 but differs from the active area 43 in that the source region 34 is omitted so that the body region 33 extends to the first major surface 12. The edge termination region 44 also includes an outer edge termination region 46 which surrounds the inner edge termination region 45.

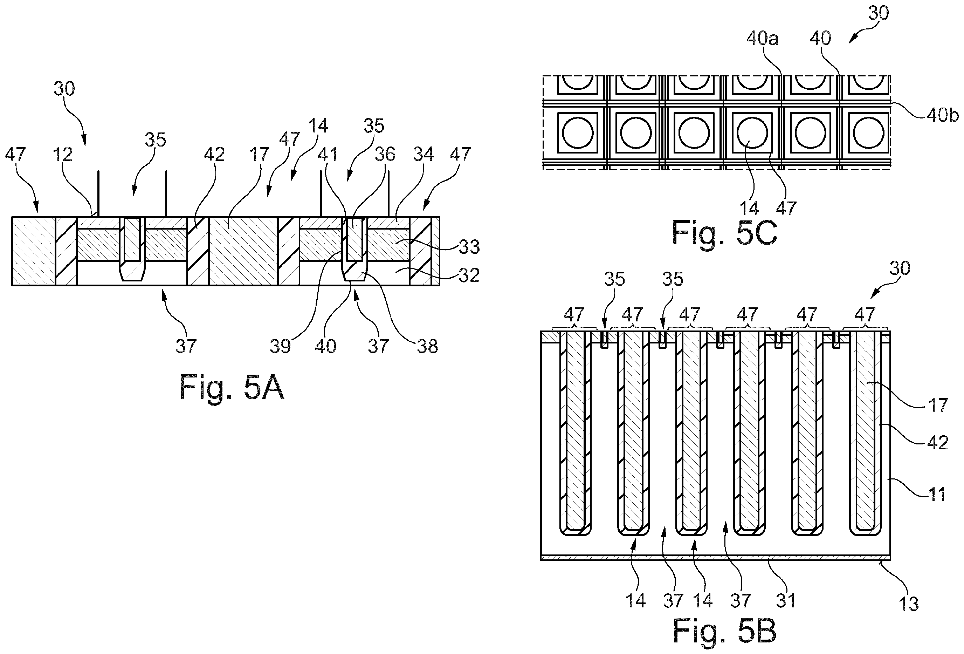

Referring to figure 5 and the enlarged cross-sectional view of figure 5A, the interface layer 41 is then structured to form an opening 47 which is positioned above the trench 14. The trench 14 including the field plate 17 and sacrificial material 42 and the contiguous region of the first major surface 12 surrounding the trench 14 are exposed from the interface layer 41 due to the opening 47. The gate trench 35 and a contiguous region of the first major surface 12 surrounding the gate trench 35 remains covered by the interface layer 41. As can be seen in the top view of figure 5C, in this embodiment, the opening 47 has a square form and is concentric with the square grid 40 of the gate trench 35. The entire circular trench 14 and regions of the first major surface 12 immediately adjacent the trench 14 are exposed from the interface layer 41.

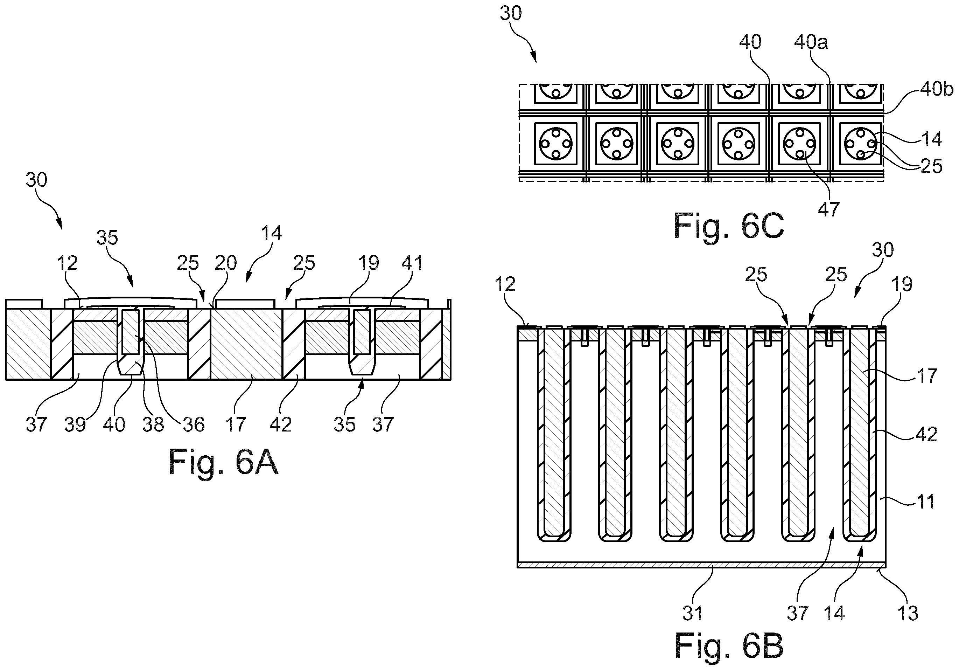

Referring to figure 6 and the cross-sectional views of figures 6A and 6B, the anchoring layer 19 is then deposited onto the first major surface such that it entirely covers first major surface 12 including the mesas 37, the gate trenches 35 and the trenches 14. At least one opening 25 is then formed in the anchoring layer 19 which is positioned at least partly above the sacrificial material 42 arranged in the trenches 14 in the active area 43. Openings 25 in the anchoring layer 19 may also be positioned above each of the trenches 14 the edge termination region 44 as well as in the active area 43.

As can be seen in the top view of figure 6C, four openings 25 are formed to each trench 14, each having a substantially circular shape, which are arranged uniformly above the sacrificial material 42 in the trench 14. The four openings for each circular trench 14 may be positioned at the corners of a square. The remaining regions of the anchoring layer 19 extend between the openings 14 and therefore between the first major surface 12 of the semiconductor substrate 11 and the upper surface 20 of the field plate 17. The anchoring layer 19 completely covers the remaining regions of the interface layer 41 which are positioned on the mesas 37 above the gate trenches 35. The anchoring layer 19 is in these regions, in direct contact with the interface layer 41. The anchoring layer 19 is, however, in direct contact with the first major surface 12 of the semiconductor substrate 11 and therefore with the semiconductor material of the semiconductor substrate 11 at regions immediately adjacent, i.e. contiguous, the trenches 14 and is also in direct contact with the material of the upper surface 20 of the field plate 17. The anchoring layer 19 also extends onto and is in direct contact with regions of the sacrificial material 42 which are not exposed by one of the openings 25.

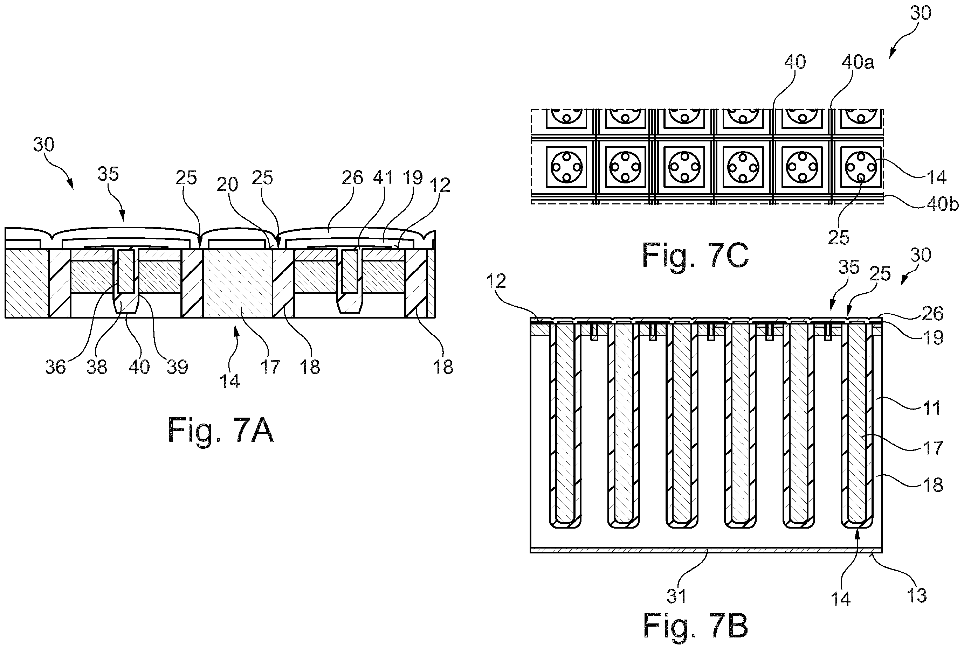

Referring to figure 7 and the cross-sectional views of figures 7A and 7B, at least some of the sacrificial material 42 is removed from the trenches 14 through the openings 25 in the anchoring layer 19, for example by an etching process. A plasma etch and/or a wet etch may be used. As can be seen in the cross-sectional view of figure 7B, in this embodiment, all of the sacrificial material 42 within the trenches 14 is removed such that the field plate 17 is spaced apart from the sidewall 16 and from base 15 of the trench 14 by a gap.

The sacrificial material 42 is selectively etchable over the material of the anchoring layer 19 such that the anchoring layer 19 forms a supporting web between the first major surface 12 the semiconductor substrate 11 and the upper surface 20 of the conductive material of the field plate 17 during and after the removal of the sacrificial material 42 from the trench 14. Since the interface layer 41 is entirely covered by the anchoring layer 19 it does not come into contact with the etching medium. Consequently, the sacrificial material 42 does not have to be selectively etchable over the interface layer 41. The interface layer 41 can even be formed of the same material as the sacrificial material 42 since it is not attacked by the etching medium due to the intervening anchoring layer 19. A suitable combination of materials is SiO₂ for the interface layer 41 and the sacrificial material 42, polysilicon for the field plate 17 and silicon nitride for the anchoring layer 19.

After the sacrificial material 42 has been removed from the trench 14 to the degree required by the application, a sealing layer 26 is deposited onto the first major surface 12 such that it extends over the anchoring layer 19 and over the openings 25 formed in the anchoring layer 19 and such that the sealing layer 26 seals the openings 25 and forms the enclosed and sealed cavity or void 18 within the trenches 14. The sealing layer 26 may fill or partially fill the openings 25 and may also extend slightly into the upper portion of the trench 14 in order to seal the etches process environment, e.g. a vacuum, within the cavity 18.

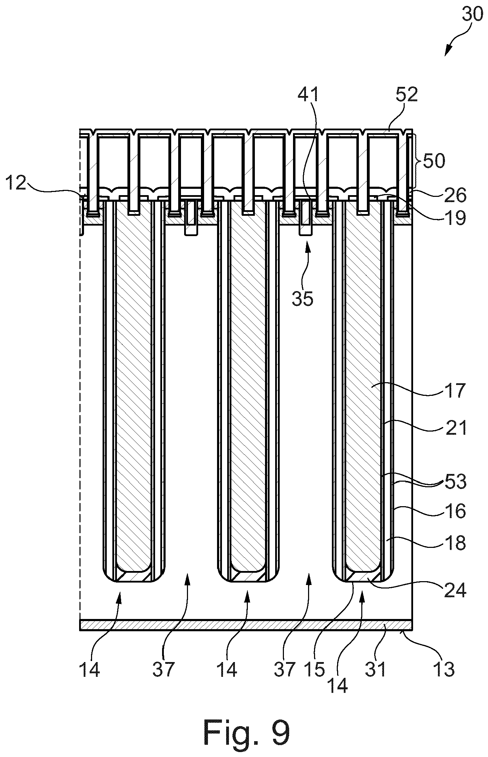

In the embodiment illustrated in figure 7, the trenches 14 arranged in the edge termination region 44 also comprise a cavity. In other embodiments, one or more of the trenches 14 in the edge termination region 45 may comprise solid dielectric material, e.g. the sacrificial material 42, to electrically insulate the conductive member from the semiconductor substrate 11. This is easily achieved by structuring the anchoring layer 19 such that no openings formed above this the respective trench in the edge termination region. Figure 9 illustrates an example of this arrangement.

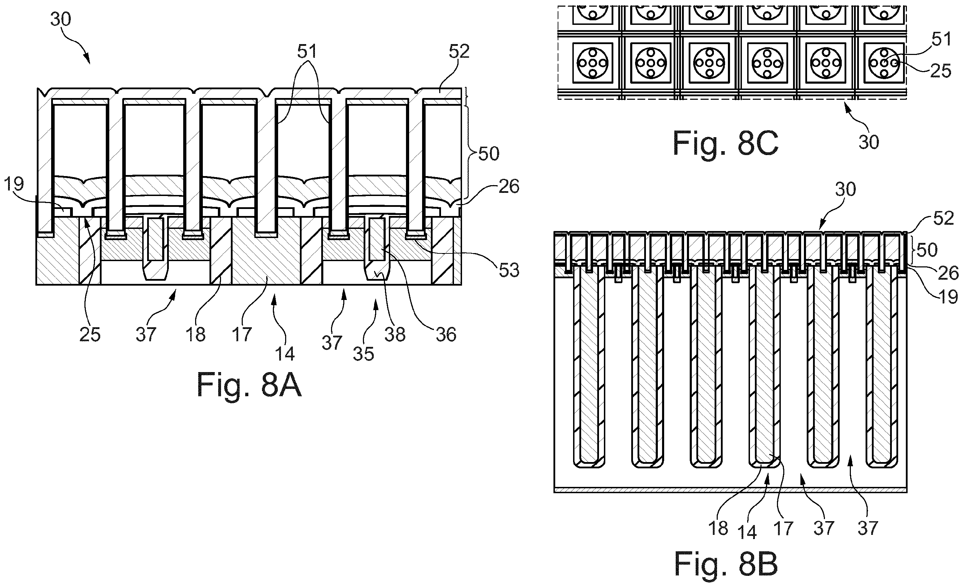

Referring to figure 8 and the cross-sectional views of figures 8A and 8B, one or more further dielectric layers 50 may be formed on the sealing layer 26 and an opening 51 formed which extend through the dielectric layer 50, the sealing layer 26, the anchoring layer 19 and the interface layer 41 into the individual ones of the mesas 37. An opening 51 is formed through the dielectric layer 50, the sealing layer 26 and the anchoring layer 19 into the conductive material of individual ones of the field plates 17. The openings 51 are then filled with conductive material 52 to provide contacts to the mesa 37 and to the conductive field plate 17. The conductive layer 52 may include two or more sublayers. The conductive material 52 may also extend over the upper surface of the dielectric layer 52 electrically couple the mesa contacts and the field plates 17 of the transistor cells to one another. Alternatively, a further conductive layer may be formed on the upper surface of the dielectric layer 50 that extends between and electrically connects the individual contacts 52 to one another.

The base of the openings 51 may extend through the source region 34 such that the base is arranged in the body region 33. In some embodiments, after the formation of the openings 51 to the mesas 37, a contact implantation at the base of the openings 51 may be performed to create a more highly doped region 53 in the body region 33 at the base of the openings 51 located in the mesas 37.

Openings may be formed through the dielectric layer 50, sealing layer 26 anchoring layer 19 and interface layer 41 to the gate electrode 36 positioned in the gate trench 35 so as to form an electrical contact to the gate electrodes 36 and electrically connect the gate electrodes of the transistor cells to one another. The openings to the gate electrode may be formed in a plane which cannot be seen in figure 8A

Figure 9 illustrates a transistor device 30 which has an active area 43 that is similar to that illustrated in figure 8. The transistor device 30 of figure 9 further comprises a liner layer 53, which lines the cavity 18. The liner layer 53 may comprise silicon dioxide and may be used to better seal the cavity 18. The liner layer 53 extends over the side wall 16 of the trench 14, the peripheral regions of the base 15 of the trench 14, the side face of the dielectric material 24, if present, and the side face 21 of the conductive member 17.

A liner layer 53 may also be used in the arrangement of the cavity 18 shown in figures 1 to 8.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a semiconductor substrate having a first major surface;
one or more trenches formed in the first major surface and having a base and a side wall extending from the base to the first major surface;
an anchoring layer;
a conductive member arranged in the trench and spaced apart from the side wall of the trench by a cavity formed in the trench, wherein the anchoring layer extends from the first major surface of the semiconductor substrate over the cavity and onto an upper surface of the conductive member.

2. A semiconductor device according to claim 1, wherein the anchoring layer comprises at least one opening that is positioned above the cavity and the semiconductor device further comprises a sealing layer that is arranged on the anchoring layer and covers the at least one opening to seal the cavity.

3. A semiconductor device according to claim 1 or claims 2, further comprising an interface layer arranged on the first major surface of the semiconductor substrate that leaves the trench uncovered.

4. A semiconductor device according to claim 3, wherein the interface layer is spaced apart from the sidewalls of the trench by a portion of the first major surface of the semiconductor substrate and the anchoring layer is in direct contact with this portion of the first major surface of the semiconductor substrate.

5. A semiconductor device according to any one of claims 1 to 4, wherein the anchoring layer is formed of a material with a Young's modulus of at least 200 GPa.

6. A semiconductor device according to any one of clams 1 to 5, wherein the trench is an elongate trench or a columnar trench.

7. A semiconductor device according to any one of claims 1 to 6, wherein the semiconductor substrate comprises a first conductivity type and a plurality of transistor cells, each transistor cell comprising a drain region of the first conductivity type, a drift region of the first conductivity type on the drain region, a body region of a second conductivity type that opposes the first conductivity on the drift region and a source region of the first conductivity type on the body region, a gate electrode, and the trench with the conductive member, wherein the conductive member provides a field plate.

8. A method of producing a cavity in a trench, the method comprising:
providing a semiconductor substrate having a first major surface, one or more trenches formed in the first major surface and having a base and a side wall extending from the base to the first major surface, a conductive member arranged in the trench and spaced apart from the base and side wall of the trench by sacrificial material;
applying an anchoring layer to the first major surface that covers the trenches and that is in contact with an upper surface of the conductive member;
forming at least one opening in the anchoring layer that exposes the sacrificial material in the trench, the anchoring layer extending between the first major surface of the semiconductor substrate in regions laterally adjacent the opening and upper surface of the conductive member;
removing at least a portion of the sacrificial material from the trench through the at least one opening;
depositing a sealing layer onto the first major surface, sealing the at least one opening and forming a cavity in the trench such that the conductive member is spaced apart from the side wall of the trench by the cavity.

9. A method according to claim 8, wherein the opening has a lateral extent that is smaller than the thickness of the sacrificial material on the side walls of the trench, or the opening has a lateral extent such that it is positioned above the sacrificial material and/or the first major surface and/or the conductive member, whereby the remaining portion of the anchoring layer extends between the conductive member and the first major surface.

10. A method according to claim 8 or claim 9, wherein a plurality of openings is formed in the anchoring layer exposing the sacrificial material in the trench and the sacrificial material is removed from the trench through the plurality of openings.

11. A method according to any one of claims 8 to 10, wherein the sacrificial material is at least partially removed by wet etching and/or plasma etching and/or gas chemistry.

12. A method according to any one of claims 8 to 11, further comprising: after removing the sacrificial material, forming a lining on the base and side walls of the trench and exposed surface of the conductive member.

13. A method according to any one of claims 8 to 12, wherein the semiconductor substrate further comprises an interface layer arranged on the first major surface of the substate and on the trenches, and the method further comprises:
removing regions of the interface layer from the first major surface such that the interface layer is spaced apart from the side walls of the trenches by a portion of the first major surface, and
forming the anchoring layer on the interface layer and directly on the first major surface of the semiconductor substrate in regions contiguous to the trench.

14. A method according to any one of claims 8 to 13, wherein the semiconductor substrate comprises a first conductivity type and a plurality of transistor cells, each transistor cell comprising a drain region of the first conductivity type, a drift region of the first conductivity type on the drain region, a body region of the second conductivity type that opposes the first conductivity type on the drift region and a source region of the first conductivity type on the body region, a gate electrode, and the trench with the conductive member, wherein the conductive member provides a field plate.

15. A method according to claim 14, wherein the gate electrode is arranged in a gate trench and is electrically insulated from the semiconductor substrate by an electrically insulating layer formed in the gate trench, and wherein after the portions of the interface layer are removed the interface layer covers the gate electrode and the gate trench.
